# EUROPEAN PATENT APPLICATION

(11) **EP 3 767 229 A1**
(43) Date of publication of application: **20.01.2021**
(21) Application number: 20192719.1
(22) Date of filing: 19.10.2006
(51) Int. Cl.: G01C 9/00, G01C 17/00, G01C 19/00, G01R 29/14, G01R 29/12

(54) **APPARATUS AND METHOD FOR DETECTION OF STRAY VOLTAGE ANOMALIES**

(30) Priority: 19.10.2005 US 728168 P
(62) Divisional of application: 06851981.8
(71) Applicant: Osmose Utilities Services, Inc., Peachtree City, GA 30269 (US)
(72) Inventor: Kalokitis, David, Robbinsville, NJ New Jersey 08691 (US); Schultz, Leonard Joshua, Holland, Pennsylvania 18966 (US); Polyzois, Christos, Bloomington, Minnesota 55438-1024 (US); Paragano, Vincent, Yardley, Pennsylvania 19067 (US)
(74) Representative: Zimmermann & Partner Patentanwälte mbB

(57) **Abstract**

An apparatus mountable to a vehicle and configured for detecting a potential stray voltage anomaly event is provided. The apparatus includes a sensor probe configured to provide electric field measurement data, and means for providing a location reference associated with the electric field measurement data. The apparatus includes a processor configured to detect, as the potential stray voltage anomaly event, a spike in the electric field measurement data that exceeds a threshold. The processor is further configured to tag the event with a corresponding location reference. The apparatus includes at least one of a memory component and a transceiver component. The memory component is configured to store the potential stray voltage anomaly event, including storing the spike in the electric field measurement data and the tagged location reference. The transceiver component is configured to communicate the potential stray voltage anomaly event, including the tagged location reference, from the apparatus to a device.

## Description

### CROSS-REFERENCE TO RELATED APPLICATIONS

This patent application claims the benefit of U. S. Provisional Patent Application No. 60/728,168, filed October 19, 2005, which is hereby incorporated by reference in its entirety.

### BACKGROUND OF THE INVENTION

### Field of the Invention

The present invention relates to the detection of electric fields. More particularly, the present invention is directed to an apparatus and method employing a video graphical user interface configured to enhance mobile detection and monitoring of stray voltage anomalies.

### Description of the Related Art

Large power distribution systems, especially those in large metropolitan areas, are subject to many stresses, which may occasionally result in the generation of undesirable or dangerous anomalies. An infrequent, but recurrent problem in power distribution infrastructures is the presence of "stray voltages" in the system. These stray voltages may present themselves when objects, such as manhole covers, gratings, street light poles, phone booths and the like become electrically energized (e.g., at 120V AC). An electrically conductive path may be established between underground secondary network cabling and these objects through physical damage to electrical insulation resulting in direct contact between electrically conductive elements or through the introduction of water acting as a conductor. These energized objects present obvious dangers to people and animals in the general public.

Detecting the existence of stray voltages by means of assessing electromagnetic radiation is not practical because the wavelength of a 60 Hz electromagnetic wave is approximately 5,000 kilometers (i.e., about 3,107 miles) in length. To effectively radiate electromagnetic waves, a radiating object (e.g., manhole cover or light pole) should represent at least 1/4 wavelength (i.e., about 776.75 miles) and a receiving "antenna" should be 1½ to 2 wavelengths away from the emitting source (about 6,214 miles). Two wavelengths is the distance required for electric and magnetic fields to come into time phase and space quadrature where they behave as a plane wave. A detection system will typically be perhaps 10 ft. to 30 ft. away from the energized object, so that detection will take place in the extreme near field where electric and magnetic fields exist in a complex temporal and spatial pattern, not as a unified electromagnetic plane wave. Thus, electric and magnetic fields must be considered and measured separately.

Due to power distribution networks typically having many miles of buried cable carrying perhaps thousands of amperes of current, the magnetic field in any one location due to such normal load is likely to be very high. Detecting magnetic fields arising from a relatively weak stray voltage anomaly would be very difficult due to the interference from strong ambient magnetic fields arising from normal loads and, therefore, it has been determined that the best way to detect a stray voltage anomaly is to assess the electric field.

Techniques for the detection of stray voltages are typically carried out by manual inspection of surrounding electrical infrastructures for signs of leaking current. An inspection team equipped, for example, with hand held detection devices may be employed to make direct physical inspections of electrical infrastructures. However, inspectors using these detection devices are typically required to make contact with portions of electrical infrastructures, such as streetlamp bases or manhole covers, in order to obtain accurate measurements for determining the existence of potentially dangerous stray voltages. These manual inspections are undoubtedly time-consuming and give a false sense of security.

Accordingly, there exists a need to provide a more efficient means for detecting and identifying sources of stray voltage anomalies over vast geographic areas, particularly, populated urban, suburban and rural areas.

### SUMMARY OF THE INVENTION

In view of the foregoing, an apparatus mountable to a vehicle and configured for detecting a potential stray voltage anomaly even according to claim 1 is provided. In addition, a method for detecting a potential stray voltage anomaly event in a patrolled environment according to claim 10 is provided.

According to an embodiment, an apparatus mountable to a vehicle and configured for detecting a potential stray voltage anomaly event includes a sensor probe configured to provide electric field measurement data, and means for providing a location reference associated with the electric field measurement data. The apparatus includes a processor configured to detect, as the potential stray voltage anomaly event, a spike in the electric field measurement data that exceeds a threshold. The processor is further configured to tag the event with a corresponding location reference. The apparatus includes at least one of a memory component and a transceiver component. The memory component is configured to store the potential stray voltage anomaly event, including storing the spike in the electric field measurement data and the tagged location reference. The transceiver component is configured to communicate the potential stray voltage anomaly event, including the tagged location reference, from the apparatus to a device.

According to another embodiment, a method for detecting a potential stray voltage anomaly event in a patrolled environment is provided. The method includes measuring an electric field in the patrolled environment and providing corresponding electric field measurement data, and providing a location reference associated with the electric field measurement data. The method includes processing the electric field measurement data and the location reference, wherein processing includes: detecting, as the potential stray voltage anomaly event, a spike in the electric field measurement data that exceeds a threshold, and tagging the potential stray voltage anomaly event with a corresponding location reference. The method further includes at least one of: storing the potential stray voltage anomaly event, including storing the spike in the electric field measurement data and the tagged location, and communicating the potential stray voltage anomaly event, including the tagged location, to a device.

The apparatus may include a mobile stray voltage detection system integrated with a user-controllable monitoring interface, wherein the user interface may be a video based graphical user interface configured to enhance the detection of stray voltage anomalies. Input to the mobile stray voltage detection system may be provided at least by the sensor probe, for instance by at least one vehicle mounted sensor probe which is sensitive to the presence of an electric field in at least one axis. Such a vehicle mounted sensor probe system is described, for example, in U.S. Patent Application Nos. 11/224,909 and 11/224,910, which are hereby incorporated by reference. The vehicle may additionally be mounted with at least one camera unit for recording a scene being patrolled for stray voltage anomalies using the vehicle mounted sensor probe. Intensity of electric field signals may be communicated to an operator through means of an audio tone that is pitch proportional to strength of the field detected, and/or through a visual display, and both user communication means may be controllable through the user interface. Distance traveled by the vehicle, and/or GPS positions of the vehicle throughout various points of the vehicle's travel, may be provided as location reference input to the mobile stray voltage detection system in order to tag the location of measured electric fields and further assist the operator in isolating an anomaly-emitting source.

In accordance with some embodiments of the present invention, the graphical user interface may provide a video display for depicting a graphical representation of the electric field signal strength and corresponding video image of a patrolled scene. Vehicle mounted camera units may present video images of the passing scene on the video display portion of the user interface. Signals measured by the sensor probe may be analyzed by a processing unit to produce a "moving chart" graphical display of the electric field strength. The graphical display of the measured field strength may be associated with and overlaid on the video images of the patrolled scene, thereby assisting a user to isolate and associate the source of the stray voltage anomaly to specific infrastructures depicted in the patrolled scene.

### BRIEF DESCRIPTION OF THE DRAWINGS

The above and other advantages of the present invention will become apparent upon consideration of the following detailed description, taken in conjunction with the accompanying drawings, in which like reference characters refer to like parts throughout, and in which:
**FIG. 1** illustrates a block diagram of an exemplary apparatus suitable for implementing the stray voltage detection methods employed in accordance with an embodiment of the present invention.
**FIG. 2** illustrates an exemplary login display produced by a system in accordance with an embodiment of the present invention.
**FIG. 3** illustrates an exemplary main display produced by a system upon successful logging in of an operator at the illustrative display in FIG. 2 in accordance with an embodiment of the present invention.
**FIG. 4** illustrates the main display of FIG. 2 depicting streaming data of measured electric fields and corresponding video images of a patrolled scene in accordance with an embodiment of the present invention.
**FIG. 5** illustrates an exploded view of an exemplary monitoring control panel provided on the main displays of FIGS. 3 and 4 in accordance with an embodiment of the present invention.
**FIG. 6** illustrates an exemplary standby display produced by the system upon selection of an event capture option provided on the main displays of FIGS. 3 and 4 in accordance with an embodiment of the present invention.
**FIG. 7** illustrates an exemplary event capture display produced by the system upon completion of the processing for a request to capture an event in accordance with an embodiment of the present invention.
**FIG. 8** illustrates an exploded view of plotted electric field measurements and a location indicator provided on the playback display of FIG. 7 in accordance with an embodiment of the present invention.
**FIG. 9** illustrates an exploded view of plotted electric field measurements and a potentially electrified source provided on the playback display of FIG. 7 in accordance with an embodiment of the present invention.
**FIG. 10** illustrates an exploded view of an exemplary playback control panel provided on the event capture display of FIG. 7 in accordance with an embodiment of the present invention.
**FIG. 11** illustrates an exploded view of an exemplary anomaly identification sub-panel provided on the playback control panel of FIG. 10 in accordance with an embodiment of the present invention.
**FIG. 12** illustrates an exploded view of an exemplary event log sub-panel provided on the playback control panel of FIG. 10 in accordance with an embodiment of the present invention.
**FIG. 13** illustrates an exemplary preferences display produced by the system upon selection of a preferences option provided on the displays of FIGS. 3, 4 and 6 in accordance with an embodiment of the present invention.
**FIG. 14** is a flowchart illustrating steps employed by the system monitoring electric fields in accordance with an embodiment of the present invention.

It is to be understood that the above-identified drawing figures are for purposes of illustrating the concepts of the present invention and may not be to scale, and are not intended to be limiting in terms of the range of possible shapes and proportions of the present invention.

### DETAILED DESCRIPTION OF THE PREFERRED EMBODIMENTS

The present invention is directed towards a mobile apparatus and method for monitoring and controlling the detection of stray voltage anomalies in a patrolled environment. For purposes of clarity, and not by way of limitation, illustrative depictions of the present invention are described with references made to the above-identified drawing figures. Various modifications obvious to one skilled in the art are deemed to be within the spirit and scope of the present invention.

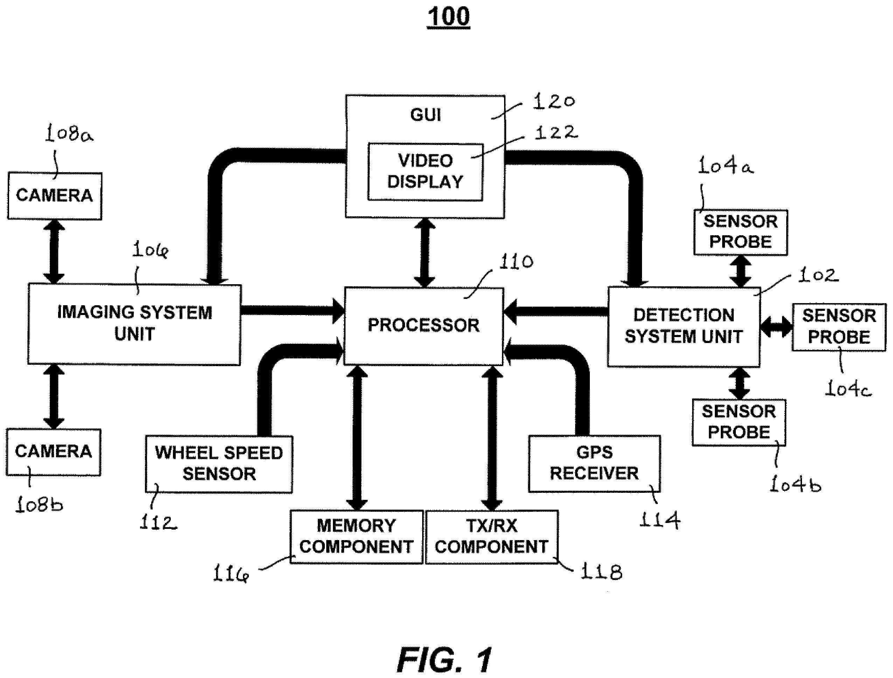

An exemplary apparatus **100** for implementing the present invention is illustrated in **FIG. 1****.** In accordance with an embodiment of the present invention, apparatus **100** includes a detection system unit (DSU) **102,** which may receive electric field measurements from sensor probes **104a, 104b** and **104c.** DSU **102** may employ any number of sensor probes for purposes of measuring an electric field in any particular area of interest being surveyed for stray voltage anomalies. For example, DSU **102** may employ only one of said sensor probes **104a, 104b** or **104c,** additional sensor probes to supplement the measurements obtained by sensor probes **104a, 104b** and **104c** or, alternatively, any other suitable combination of sensor probes. According to another embodiment, DSU **102** may employ a multi-axis sensor probe arrangement as the ones described, for example, in U.S. Patent Application Nos. 11/224,909 and 11/224,910, which are hereby incorporated by reference in their entirety.

Apparatus **100** of **FIG. 1** may additionally include an imaging system unit (ISU) **106,** which may receive video input from cameras **108a** and **108b.** Similar to DSU **102,** ISU **106** may employ any number of cameras suitable for providing streaming images of a patrolled scene. Cameras employed in apparatus **100** may be video cameras, stereo cameras, various digital cameras, a combination of the aforementioned cameras or any other suitable camera and arrangement of cameras suitable for imagining a patrolled scene.

One or more of cameras **108** may be provided for imaging the environs where apparatus **100** is employed. Specifically, where apparatus **100** is deployed on a patrol vehicle or trailer (not shown), cameras **108a** and **108b** may be provided thereon, wherein camera **108a** is directed to view in a direction about 90° to the left of the direction of travel and camera **108b** is directed to view about 90° to the right of the direction of travel, so that images of what is present to the left and to the right of the patrolling vehicle are obtained. Video images therefrom may be recorded as apparatus **100** traverses a patrolled environment.

Video images may be obtained at a standard video rate, e.g., at 30 or 60 frames per second, but may be at much slower rates, e.g., one or two frames per second, consistent with the speeds at which the patrolling vehicle moves. For example, if a vehicle is moving at between 10 and 20 mph (about 14-28 feet per second or about 4.2-8.5 m/sec.), video at a two frames per second video rate would provide a new image for approximately each 14 feet (about 4.2 m) or less of travel, which should be sufficient to identify the location at which the stray voltage was detected.

The video images may all be recorded (stored) or only selected images may be recorded. In one exemplary embodiment, video images are stored in a video frame data buffer having a capacity to store a substantial number of frames of video data, e.g., frames representing about thirty (30) seconds of video scenes. As each new frame is stored, the oldest previous frame is lost. Thus, the video data buffer contains video frames for the most recent thirty seconds. Video buffers storing frames representing a longer period of time, or even a shorter period of time, may be employed. For example, a "frame grabber" card, in the form of a PCMCIA card or an internal card, may be employed to synchronize processed electric field data from DSU **102** with processed video data from ISU **106.**

DSU **102** and ISU **106** may be coupled to a processor **110.** DSU **102** and ISU 106 may perform preprocessing of signals received, respectively, from sensor probes **104a-104c** and cameras **108a-108b** or, as previously described, any alternative arrangements of sensor probes and cameras prior to transmitting data to processor **110.** Processor **110** coupled to DSU **102** and ISU **106** is capable of processing sensor probe measurement data and corresponding video frame data in near real time (e.g., with less than one second latency). For example, processor **110** may be arranged to interface directly to a three-axis stray voltage sensing probe arrangement, as described in U.S. Patent Application Nos. 11/224,909 and 11/224,910. Processor **110** may include a plurality of electronic components (not shown) such as a multi-channel analog-to-digital converter (ADC), a digital signal processor (DSP), a memory (e.g., an EEPROM), an audio amplifier, audible transducing device (e.g., a loudspeaker), one or more data converters (e.g., uni-directional or bidirectional SPI to RS-232 converters), a source of electrical power (e.g., a power converter operating from a vehicle power system) or any other applicable electronic processing component.

In addition, a wheel speed sensor **112,** a global positioning system (GPS) receiver **114,** a memory component **116,** a transceiver component **118** and a graphical user interface (GUI) **120** may also be coupled to processor **110.** Data pertaining to the speed and distance of travel of a patrolling vehicle may be provided to processor **110** by wheel speed sensor **112.** Wheel speed sensor **112** may be employed in the processing of electric field data to facilitate signal processing while apparatus **100** is in motion as described herein.

Data pertaining to the position of a patrolling vehicle equipped with GPS receiver **114** may be provided to processor **110** to determine exact locations of the patrolling vehicle's path of travel at the time particular electric field measurements were received. GPS receiver **114** may be configured to provide the location reference, including latitude, longitude, elevation, time and date about once per second so that the location is known to a reasonably high precision. GPS position data may be exported to a conventional GPS mapping software for utilization and then stored, for example, in memory component **116,** so that there is a stored precision location and time reference associated with the stored electric field measurements. Memory component **116** may additionally be utilized to store, temporarily or permanently, other data pertaining to electric field measurements, video images or any other data associated with the stray voltage detection process described and referenced herein.

Since apparatus **100** may be operated in urban/city environments where buildings and other obstacles distort and/or block signals from a GPS satellite system from reaching GPS receiver **114** via a direct path, GPS location information may have degraded accuracy, or may not be available. In those cases, wheel speed sensor **112** may be provided as a suitable substitute for highly accurate GPS location information, or may be utilized in conjunction therewith.

Thus, the GPS location data provides a record of the location at which each detected stray voltage anomaly was detected and the time thereof, as may be desired for subsequent analysis, for example, for reviewing the location of the anomaly and identifying the emitting source in the patrolled environment. Since the peak of a response to a source of stray voltage cannot be ascertained until after the patrolling vehicle has passed the source, the exact location of the source may not be observed until after the time at which it is detected (i.e. until after it is passed). While having this stray voltage and location data recorded is desirable and beneficial, in a typical service environment, e.g., on a city street, it is not practical to stop the patrolling vehicle carrying apparatus **100** each time a stray voltage is detected, or to back the vehicle up to ascertain the exact location at which the detection took place.

Transceiver component **118** may be configured to transmit and receive data transmissions to and from remote transceivers. Transceiver component **118** may be transceivers of the type that are compatible with Wi-Fi standard IEEE 802.11, BLUETOOTH™ enabled, a combination of local area network (LAN), wide area network (WAN), wireless area network (WLAN), personal area network (PAN) standards or any other suitable combination of communication means to permit robust wireless transmission of data. For example, transceiver component **118** may be a BLUETOOTH™ enabled device, thereby providing a means for communicating stray voltage related information between mobile apparatus **100** and a remote device, such as a personal digital assistants (PDAs), cellular phones, notebook and desktop computers, printers, digital cameras or any other suitable electronic device, via a secured short-range radio frequency. Thereafter, a utility member equipped with the remote device configured to receive the stray voltage related communication may be dispatched to a site determined to have a potential stray voltage anomaly for purposes of neutralizing the anomaly. It should be noted that the aforementioned are provided merely as exemplary means for wireless transmission of stray voltage related data. Other suitable wireless transmission and receiving means may be employed in the present invention.

An optional laptop computer (not shown) or other suitable computing system having a display may provide GUI **120** for an operator to control the operation of apparatus **100,** particularly measurement and processing components associated with sensor probes **104,** and to monitor electric field data as measured. For example, an operator may adjust the values of the constants and scaling factors utilized in the detection and averaging processing for producing an audible alarm (described in detail below). The laptop computer may also provide a convenient means for storing a record or log of the measured field and location (GPS) data for subsequent review and/or analysis, as might be desired for determining when and where a stray voltage anomaly existed.

GUI **120** may receive data, directly or indirectly, from various components described in conjunction with apparatus **100** and, accordingly, displays them to the operator for purposes of controlling and monitoring the detection of stray voltage anomalies present in patrolled areas. GUI **120** may be a video based interface having a video display **122.** The data provided to GUI **120** may provide the interface operator with an opportunity to visually monitor and analyze incoming data measured by a stray voltage detection system on video display **122.**

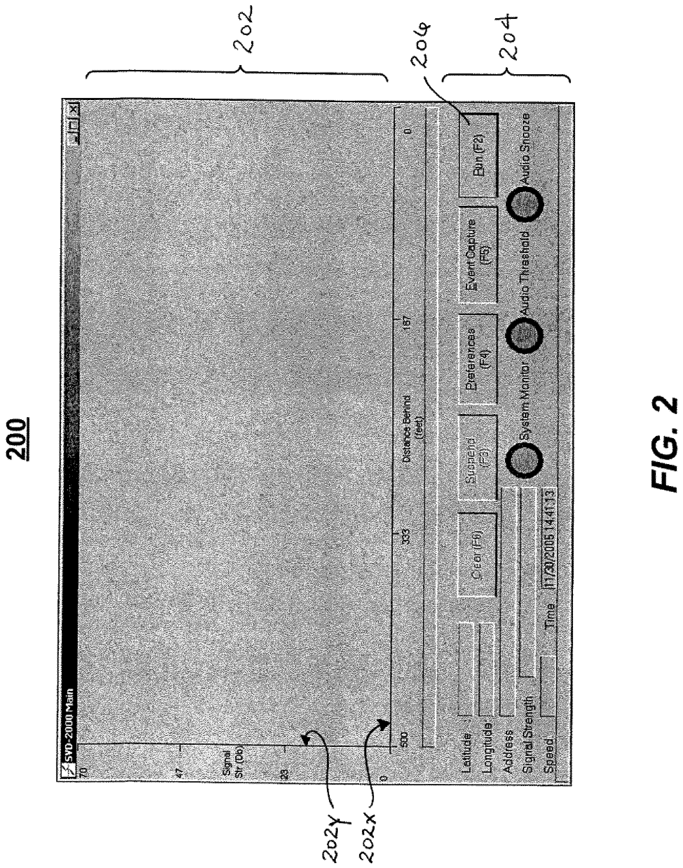

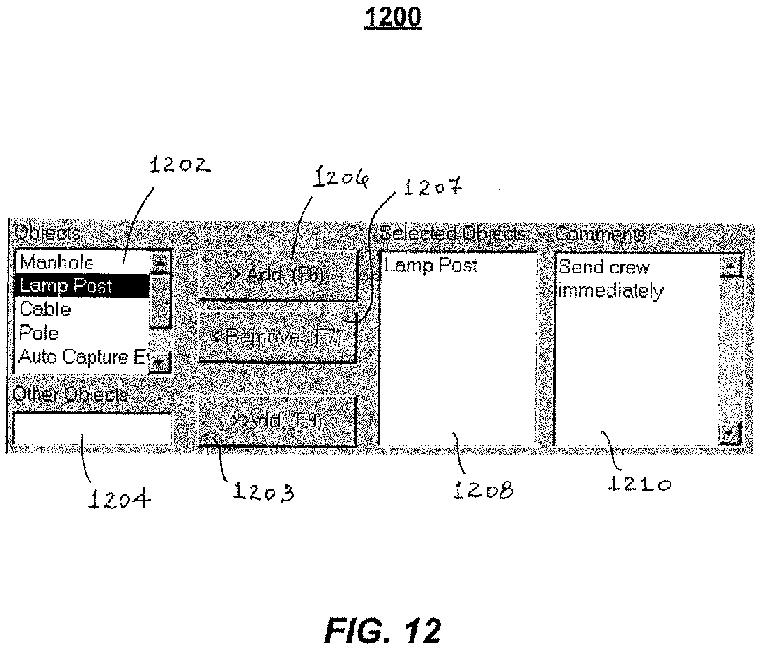

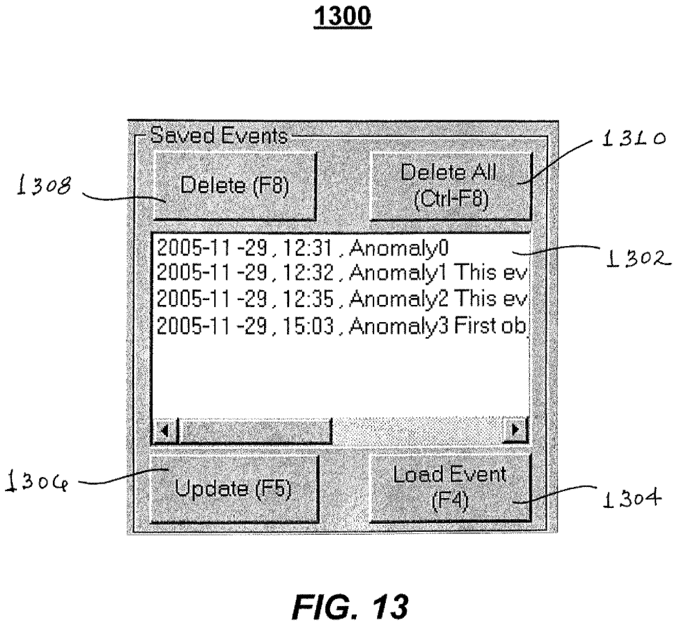

**FIGS. 2-13** illustrate exemplary displays that may be provided on video display **122** of GUI **120** for monitoring and controlling the operation of apparatus **100.** As previously described, GUI **120** may be provided on a computer, preferably a laptop computer for purposes of mobility. Upon start up of GUI **120** of apparatus 100, for example, by selecting or clicking an icon displayed on the "desktop" provided on a monitor display of a computer, a computer program for providing GUI **120** may initialize a main display **200,** as illustrated in **FIG. 2****.** Main display **200** provides an interface user with a real-time monitoring environment of the area being patrolled for stray voltage anomalies. Main display **200** may be comprised of a video display **202** and a control panel **204.** Real-time electric field measurements and video frames of the patrolled environment may be provided in video display 202, which may be supplemented with a graphical plot having an x-axis **202x** indicative of the linear distance traveled by the patrol vehicle versus a y-axis **202y** indicative of the signal strength of the measured electric field associated with various locations of the patrol vehicle. In order to initiate the detection and monitoring system of apparatus **100,** the interface user may select a run command option **206** provided on display **200.**

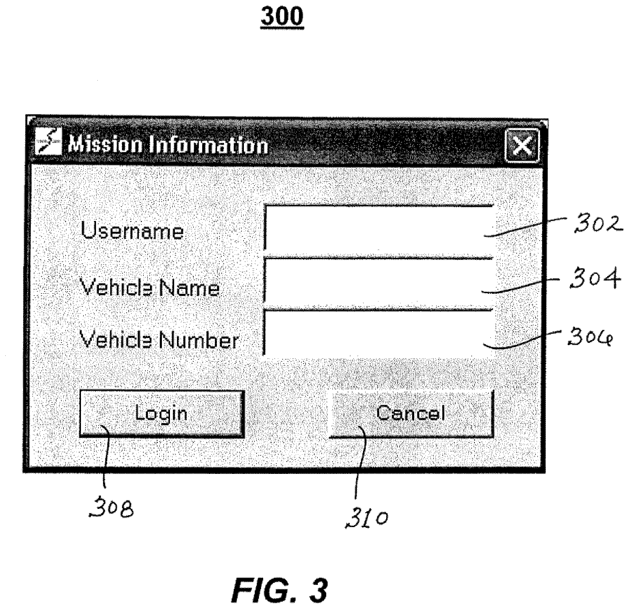

Run command option 206, when selected, may prompt for information to be entered in an initial identification screen. The initial identification screen may be, for example, system login display **300** of **FIG. 3****.** System login display **300** may request an the interface operator to provide a user name in field **302,** a patrol vehicle name in field **304** and a patrol vehicle number in field **306** for purposes of authorizing access to the operational and monitoring controls of apparatus **100.** When the required information has been provided by the interface operator in fields **302, 304** and **306,** the interface operator may then select login command option **308** to proceed with system verification of authorized access to apparatus **100.** Similarly, the interface operator may select cancel command option **310** to terminate login procedures for apparatus **100.**

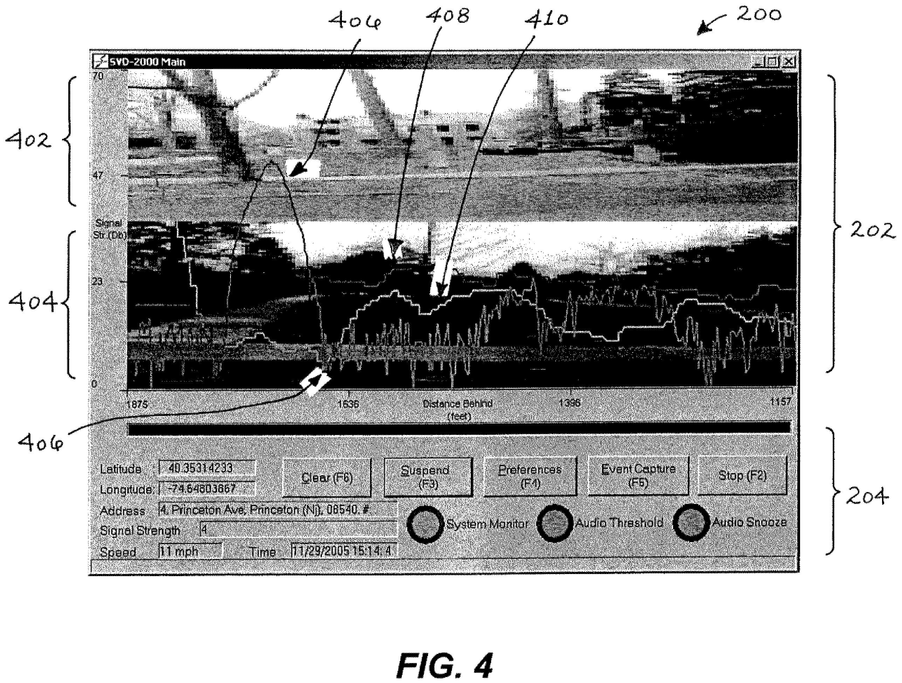

Upon a successful login at display **300,** data sampling may be initiated and main display **200** is populated with sensor data, as illustrated in the main display of **FIG. 4****.** Sensor data is provided on video display **202,** which may be provided in a split screen format for displaying multiple video image frames (one from each camera). A split screen view **402** may display video image frames received from camera **108a,** while a split screen view **404** may display corresponding video image frames received from camera **108b,** or vice versa. For example, a patrol vehicle may be equipped with cameras **108a** and **108b** positioned on opposing sides for providing corresponding video image frames from both sides of the patrol vehicles path of travel. Although main display **200** of **FIG. 4** is shown with two split screens **402** and **404,** additional split screens may be incorporated into video display **202** for an apparatus utilizing more than two cameras.

Three plot lines, a raw electrical field measurement plot **406,** an adaptive threshold plot **408** set relative to the local ambient or background noise level and a smoothed plot **410** are provided in conjunction with the graphical plot overlaid on the video image frames displayed on video display **202.** Adaptive threshold plot **408** is generated from data gathered before and after the raw voltage was sensed by sensor probes **104a-104c.** Smoothed plot **410** is a smoothed version of plot **406** that has been filtered to remove spurious content. A potential stray voltage is indicated when smoothed plot **410** exceeds adaptive threshold plot **408.**

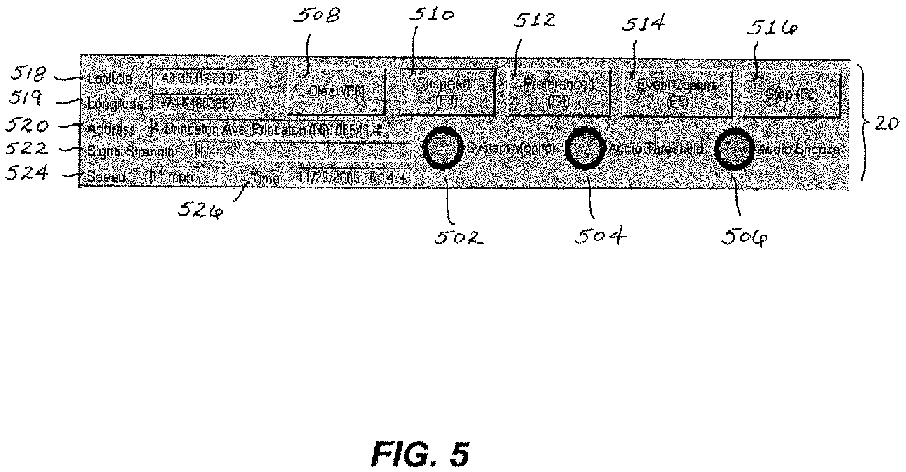

Control panel **204** of main display **200** provides the interface operator with a plurality of monitoring and control options. An enlarged view of control panel **204,** as illustrated in **FIG. 4****,** is provided and described in connection with **FIG. 5****.** Control panel **204** may include a system monitor indicator **502,** an audio threshold indicator **504** and an audio snooze indicator **506.** In addition, a clear command option **508,** a suspend command option **510,** a preferences command option **512,** an event capture command option **514** and a stop command option **516** are provided to the interface operator in control panel **204.** Control panel **204** may also provide information in a latitude display **518,** a longitude display **519,** an address display **520,** a signal strength display **522,** a speed display **524** and a time stamp display **526.**

Indicators **502, 504** and **506** may be visual indicators, configured to change color or blink upon satisfaction of preprogrammed criteria. System monitor indicator **502** may be a green color when operating within system specifications. When a problem is detected in connection with GUI **120,** system monitor indicator **502** may turn yellow to notify the interface operator that there exists a problem, such as, lack of a GPS signal. In this case, no latitude, longitude or address information may be shown, respectively, in displays **518, 519** and **520.** Another potential trigger indicative of a problem is lack of video or electric field measurement data, wherein there would be no video image frame or measurement readings on video display **202.** Other potential problems that may trigger indicator 502 may be depleted disk space for recording captured events (described in detail below) or loss of communication between processor **110** and GUI **120.**

Generation of an audible tone output signal having a pitch that is proportional to the signal strength of the measured electric field may be provided as a tool in conjunction with the monitoring capabilities provided in GUI **120** to aid the interface operator in determining the source and potential danger of stray voltage anomalies. An audio threshold value that is indicative of the minimum voltage level required to trigger an audible notification tone is desired. For example, an optimum audio alert value for identifying stray voltage anomalies, while minimizing the number of false detections, may be preset as a default value. Default settings may be represented by audio threshold indicator **504** being, for example, a green color.

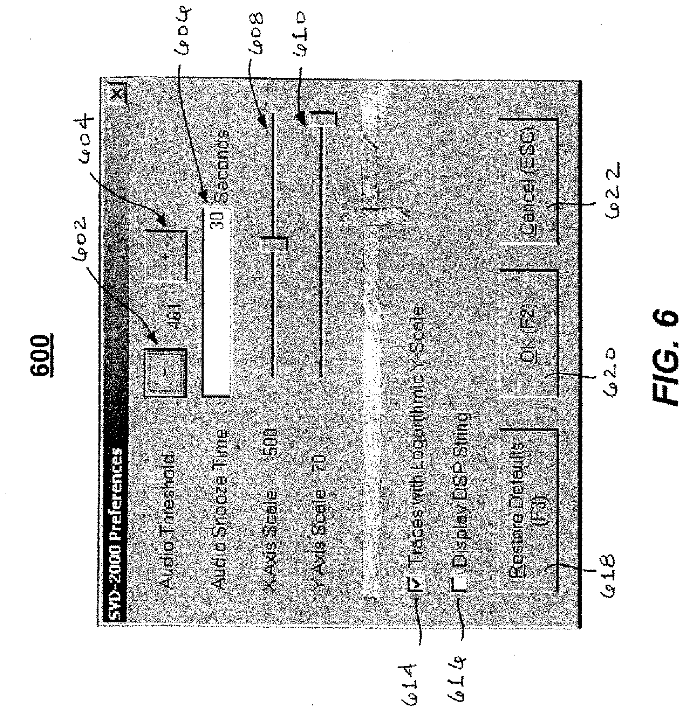

However, the interface operator may adjust the default threshold settings provided in connection with the audible notification tone if too much noise is being picked up. By selecting preferences command option **512** provided on control panel **204,** the interface operator could be provided with a preferences display **600,** as illustrated in **FIG. 6****,** for modifying values associated with the audible tone. Therein, the interface operator could raise the threshold value, using audio threshold increase button **602** and decrease button **604,** to minimize or eliminate false audible tones being generated due to a noisy environment in a patrolled environment. Any changes made to the default audible threshold value in preferences display **600** may be represented by audible threshold indicator 504 on control panel **204** turning yellow. The change in color informs the interface operator that the audible notification tone is operating according to user defined values, not system defined default values.

Additional features that may be provided in preferences display **600** of **FIG. 6** may be an audio snooze time option **606,** an x-axis toggle switch **608,** a y-axis toggle switch **610,** a trace option **614** and a DSP string option **616.** Audio snooze time option **606** specifies in seconds how long audio alerts are suspended when a snooze button **506** is pushed. Snooze button **506** may be green when default values are provided in the display of snooze time option **606** of preferences display **600.** However, similar to audio threshold indicator **504,** snooze button **506** may also include a color indicator that changes, for example, to yellow when the default snooze time has been changed in preferences display **600.** Toggle switches **608** and **610** permit the interface operator to adjust, respectively, the scale used in x-axis **202x,** which measures in feet the distance traveled since the last event capture, and y-axis **202y,** which measures in decibels the electric field signal strength, on video display **202.** Trace option **614,** when selected, allows for the logarithmic scaling of all y-axis **202** values in order to ensure that values are easily readable and that entire plot lines appear within video display **202** of main display **200.** DSP string option **616** may be provided as a means for displaying processing related data, when selected, to troubleshooting apparatus **100.**

Default values for system preferences identified in display **600** may be restored by selecting a restore defaults command option **618.** Otherwise defined preferences may be saved and executed by selecting an "OK" command option **620.** Alternatively, if the interface operator decides not to make any changes, then a "CANCEL" command option 622 may be selected. Selection of either command option **620** or **622** will return the interface operator to display **200.**

As the patrol vehicle traverses through an environment, synchronized data of the electric field strength overlaid on the corresponding video frames of the scene being traversed at the time of measurement may be displayed to the interface operator on video display **202** of main display **200.** In addition, corresponding latitude and longitude information related to the patrolling vehicle is received by GPS receiver **114** and provided, respectively, to display fields **518** and **519.** An address corresponding to the latitude and longitude readings provided in display fields **518** and **519** may also be provided in display field **520.** A signal strength value may be provided in display field **522.** The speed of the patrol vehicle may be presented in display field **524,** along with a current data and time stamp in display field **526.** The interface operator may temporarily suspend data sampling at any time by selecting a suspend command option **510,** clear received data by selecting a clear command option 508 or exit GUI **120** system entirely by selecting a stop command option **516** provided on control panel 204 of main display **200.**

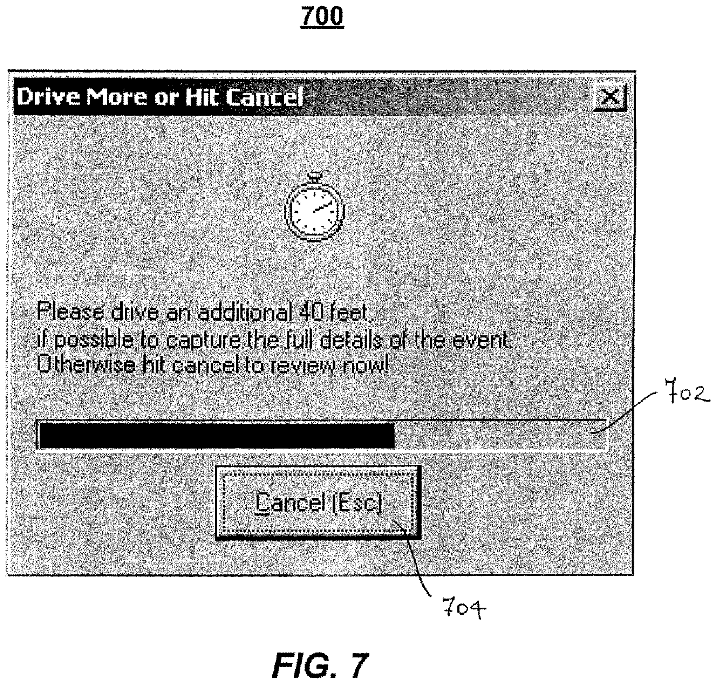

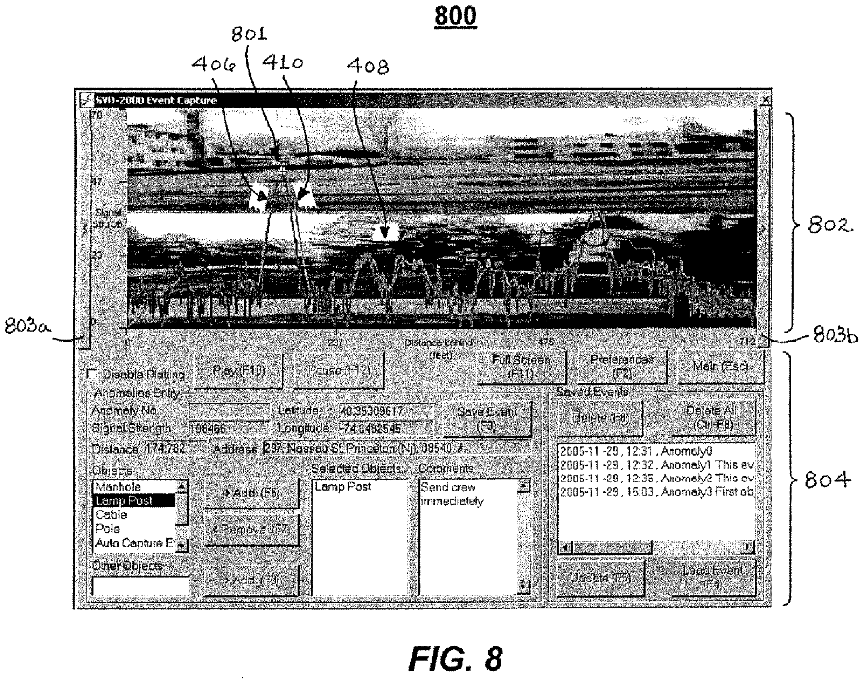

As the interface operator monitors the incoming streaming data on video display **202,** he/she may be presented with a variable-pitch alert that is configured for alerting the interface operator of detected fluctuations and/or spikes in measured electric field readings that exceed a defined threshold. Therefore, when a potential anomaly is detected, represented for example by a rise-peak-fall in the alert pitch, a corresponding visual spike in raw voltage plot **406,** a high signal strength value in display field **522** or a combination thereof, interface operator may select an event capture command option **514** for purposes of gathering additional information to review the potentially detected stray voltage anomaly. Therefore, when the interface operator selects event capture command option **514** on control panel **204** of main display **200,** he/she may be presented with a data collection display 700 and a event capture display **800** illustrated, respectively, in **FIGS. 7** and **8****.** Data collection display **700** prompts the interface operator to continue driving the patrol vehicle for a predefined distance (e.g., an additional 40 feet after selection of event capture command option **514**) in order to collect enough data sampling information to fully analyze the background noise associated with the captured event. A progress bar **702** may be provided in display **700** to inform the interface user of the remaining distance of travel required. Upon completion of the additional information collection process, represented by progress bar **702,** the interface operator may stop the collection of streaming data by GUI **120** and proceed to event capture display **800** for analyzing the captured event. The collection of streaming data may be stopped or paused by stopping the patrol vehicle. Alternatively, collection of additional information pertaining to the captured event may be optionally terminated earlier, through selection of a cancel command option **704,** to permit the interface operator to proceed to review the captured event on event capture display **800** without collection of additional information.

After driving the additional distance prompted by display **700** and stopping the patrol vehicle, processing of data related to the event capture may be processed (e.g. by processor **110**) and a second distinctive alert tone (e.g., a chime-like sound) may be presented to the interface operator if it is determined that the processed captured measurement is not a false alarm. Thereupon, the interface operator could further examine the potential detected anomaly in event capture display **800,** as illustrated in **FIG. 8****.** Similar to main display **200,** event capture display **800** provides a video display **802** and a playback control panel **804.** Scene scroll tabs **803a** and **803b** may be provided on opposing sides of display **802** to permit the interface operator to view captured video images and their corresponding electric field measurements throughout various positions traversed by the patrol vehicle. Event capture display **800** may also provide a pinpoint indicator **801** that may be positioned on any part of the video display **802** to display data and video for a different location. Data displayed in playback control panel **804** (to be described below) corresponds to the applied position of indicator **801.** For example, if the interface operator would like to view measurement and video data associated with a position **225** feet prior in motion, the interface operator could use scene scroll tabs **803a** and **803b** to move pinpoint indicator 801 to the desired location on video display **802.**

Event capture display **800** allows the interface operator to more closely examine potentially detected anomalies by providing playback analysis of the captured event. More specifically, the interface operator may compare raw voltage plot **406** and adaptive threshold plot **408** to assist in identifying the object displayed in the corresponding image frame that is most likely to be the source of the anomaly. In event capture display **800,** the three plot lines may be aligned to permit the interface operator to look for points where smoothed plot **410** exceeds adaptive threshold plot **408.** This indicates that there exists a spike above the averaged background noise and, therefore, the existence of an anomaly.

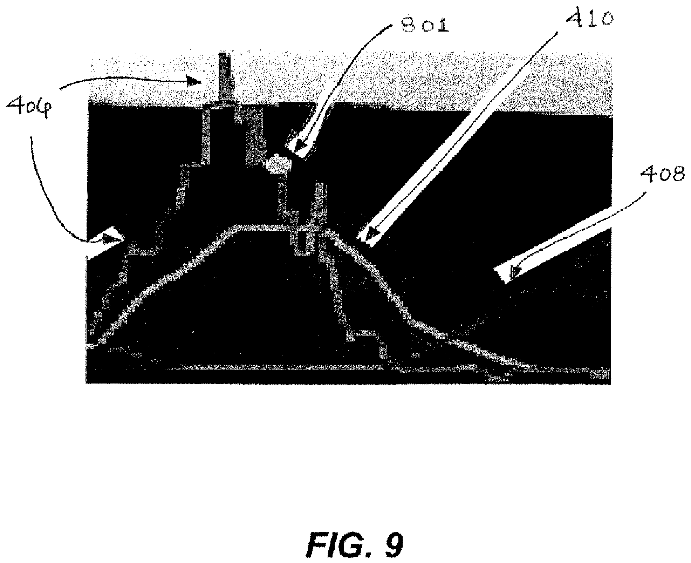

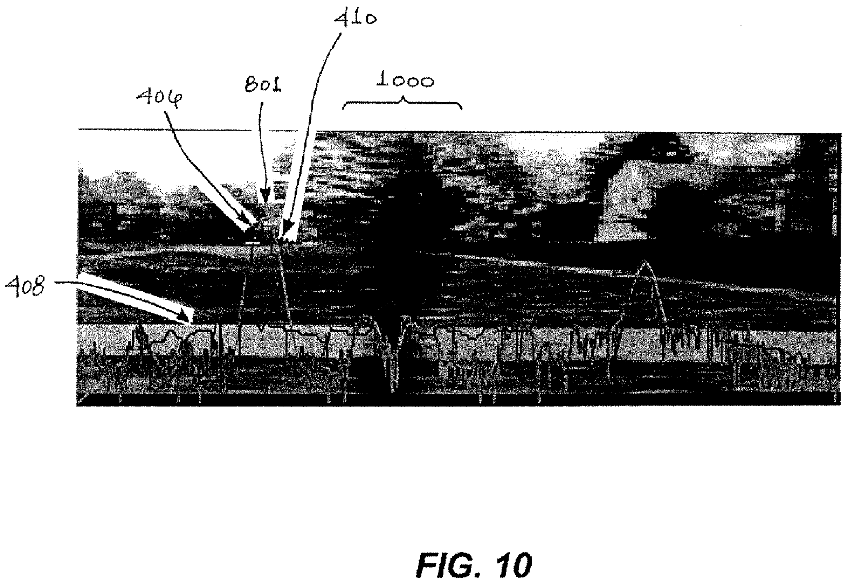

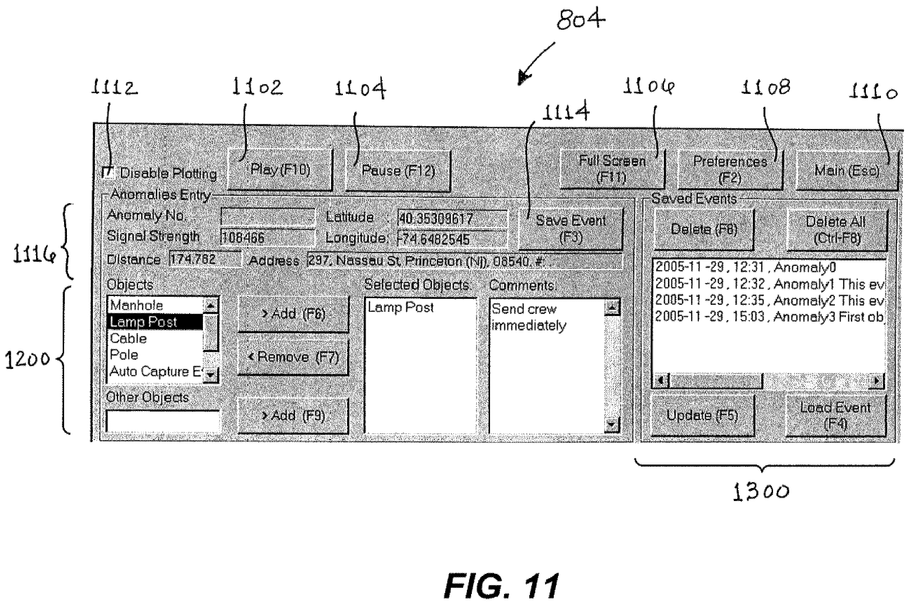

Enlarged views of a detected stray voltage anomaly as it may be provided on video display **802** of event capture display **800** of **FIG. 8** is illustrated in conjunction with **FIGS. 9-10****.** In **FIG. 9****,** pinpoint indicator **801** is positioned near the peak of spike in raw voltage plot **406.** All related sensor data related to this particular position is provided to .the interface operator on playback control panel **804.** As can be seen near the spike in raw voltage plot **406,** smoothed plot **410** exceeds adaptive threshold plot 408, indicative of a potentially dangerous anomaly in the captured scene. When pinpoint indicator **801** is positioned over the peak of a spike, the object most centered in a video frame on video display **802** is likely the source of the detected anomaly. An isolated enlarged view, as illustrated in **FIG. 10****,** of the video image frame shown on video display **802** of event capture display **800** may be provided, wherein it can be seen that an object **1000** most centered in the video frame is likely the source of the detected anomaly. The video image frame may be isolated and enlarged by selecting a full screen command option **1106** (**FIG. 11**) from playback control panel **804.**

An enlarged view of event capture control panel **804** is illustrated in **FIG. 11****.** Event capture control panel **804** is comprised of a play command option **1102,** a pause command option **1104,** a full screen command option **1106,** a preferences option **1108** and a mairi display option **1110.** Play command option **1102** may allow the interface operator to play a video clip selected from a saved events section **1300.** Similarly, pause command option **1104** may allow the interface operator to pause playback of the video clip selected from saved events section **1300.** Full screen command option **1106** may allow the interface operator to toggle between full-sized video images and regular-sized video images provided on display **802.** Preferences command option **1108** may provide the interface operator with additional playback and review options not shown on playback control panel **804.** For example, command option **1108,** when selected, may provide preferences related to wireless communication of captured events to dispatch a remote crew. Main display option **1110** may allow the interface operator to return to main display **200.** A disable plotting option **1112** may also be provided, wherein the plots may be removed for a clearer view of scene objects displayed on video display **802** when option **1112** is selected.

Once a detected stray voltage anomaly has been confirmed by the interface operator and object **1000,** for example, has been determined to be the likely source of the anomaly, the interface operator may then proceed to record object related information in an objects section **1200** of playback control panel **804.** An environmental object or infrastructure name may be listed in a predefined objects scroll menu **1202** or may be defined by the interface operator using an object identification field **1204.** The interface operator may then add the object identified in menu **1202** or field **1204** to a selected object field **1208** using, respectively, an add command option **1206** or an add command option 1203. An added object identified in field **1208** may also be removed by selecting a remove command option **1207.** Additional notes, comments and instructions may be provided by the interface operator using a comments field **1210.** For example, the interface operator may identify a lamp post, in field **1208,** as the potential source of a detected stray voltage anomaly and instruct, in field **1210,** the need for a utility crew to be dispatched immediately to the site to neutralize the source. In addition, GUI **120** is configured so that if multiple objects are determined to be present in a scene where an anomaly was detected, the interface operator may identify the multiple objects in field **1208.** The interface operator may then select a save event command option **1114** to record the identified object source of the anomaly, associated comments regarding the anomaly and anomaly location information **1116** for future reference and analysis of the captured anomaly event. Thereafter, the interface operator may return to main display **200,** via command option **1110,** and restart movement of the patrol vehicle to restart data sampling of the scene being traversed.

Captured events that have been previously saved by the interface operator may be viewed by selecting a saved event file from an events listing **1302** available in section **1300** of playback control panel **804.** To open a saved event provided in listing **1302,** the interface operator, or any other applicable user, may select the desired event and then select a load event command option **1304.** When the desired event is loaded, display **800** is populated with all data related to the selected event (e.g., location information, object identification, comments, captured video image frame and corresponding measurement data). To play the video associated with a loaded event, the interface operator may move the pinpoint indicator **801** to the desired starting location on video display **802** in which he/she wishes to begin viewing and select play command option **1102.**

Information that has been populated, for example, into section **1200** may be edited. For instance, if it is determined that an object previously identified as the source of a stray voltage anomaly is not indeed the source of the anomaly, field 1208 may be edited using commands **1206** and **1207** to, respectively, add a new source and remove the inaccurate source. Once changes have been made, the interface operator may select an update command option **1306** to have the new information saved in connection with the previously saved event.

When an event is saved, apparatus **100** may be configured to generate a database entry for the saved event and create separate files for video and corresponding sensor related data. For example, apparatus **100** may be configured to create an AVI file for storing video images and all XML file for storing all other sensor related data. These files may be saved on a hard disk (e.g., memory component **116**) and retrieved when the corresponding event is selected and loaded using playback control panel **804** on event capture display **800.** If it is determined that saved events are no longer needed or have been archived elsewhere, or alternatively, if additional storage space is needed in apparatus 100, the interface operator may delete command options **1308** and **1310** provided on section **1300** of playback control panel **804.**

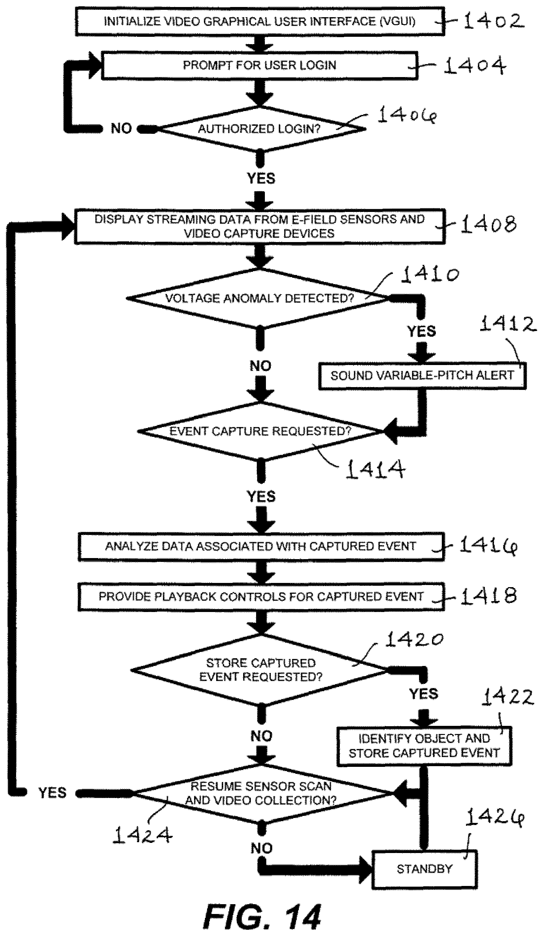

An illustrative depiction of the general steps employed in use of VGUI **120** of apparatus **100** for monitoring and controlling the detection of a stray voltage anomaly is described with reference to the flowchart of **FIG. 14****.** As previously described, the monitoring of streaming data displayed on video display **122** of GUI **120** is initiated, at step 1402, by providing user login information at step **1404.** If the login information provided at display **300** of **FIG. 3** is determined to be for an authorized user, then VGUI **120** may begin to sample data and provide a visual output of streaming data, at step **1408,** on main display **200,** which may be driven by movement of the patrol vehicle equipped with apparatus **100.**

GUI **120** of apparatus **100** may audibly, via a variable-pitched alert tone, and visually, via a spike in plots provided on graphical video display **202,** prompt the interface operator upon detection of a stray voltage anomaly at step **1410.** When initial detection of a potential anomaly is detected at step **1410,** interface operator may decide to capture the event by selecting event capture command option **514** provided on control panel **204** of main display **200.** In response to the user initiated instruction to capture an event, additional processing may be executed to collect additional information about the captured event and an additional alert notification may be provided to the interface operator at step **1416,** indicating to the interface operator that the subsequent processing of the captured event is likely a stray voltage anomaly.

Playback controls may be provided to the interface operator, at step **1418,** via control panel **804** on event capture display **800** of **FIG. 8****.** After the interface operator has had an opportunity to review information related to the captured event, as well as identify the source emitting the stray voltage anomaly at step **1422,** he/she may record the event at step **1420.** Thereafter, the interface operator may elect to resume data sampling of the area being patrolled at step **1424,** thereby reinitiating the receipt of streaming data at main display **200.** GUI **120** may go into a standby mode, at step **1426,** if no action is taken after a predetermined amount of time or, alternatively, if the interface operator elects to suspend data sampling by selecting, e.g., suspend command option ***510*** on control panel **204** of main display **200.**

According to the foregoing, a mobile stray voltage detection apparatus and method configured to sense potentially dangerous stray voltage anomalies from a moving vehicle may be provided. A mobile stray voltage detection apparatus and method configured to provide real-time awareness of detected stray voltage anomalies may be provided, enabling rapid and efficient inspection of surrounding patrolled areas. Further, a mobile stray voltage detection apparatus and method configured to provide accurate location and visual identification of potential hazards may be provided.

According to an embodiment, a mobile apparatus for monitoring an electric field in a patrolled area is provided. The mobile apparatus includes: at least one detection device for measuring electric field signals; at least one camera device for collecting video images of said patrolled area; a processor for correlating video image data collected from said camera device with electrical field signal data measured by said detection device; and a video based graphical user interface for analyzing and capturing a monitored event depicting an anomaly in said measured electric field signals. The mobile apparatus may include means for storing and/or transmitting the captured event, and may particularly include a wireless transceiver component for transmitting and receiving data associated with said captured events to and from at least one remote device. The apparatus may include a global positioning system receiver for tagging a video image frame from said collected video image data and corresponding electric field measurement with instantaneous position information pertaining to location and time. The apparatus may include a wheel speed sensor for determining a distance of travel of a patrol vehicle equipped with said mobile apparatus. The apparatus may include a means for emitting a variable-pitched tone corresponding to a strength value associated with said measured electric field signals. The apparatus may include a means for emitting an alert tone in response to a potentially detected stray voltage anomaly. Said detection device for measuring electric field signals may employ at least one sensor probe adaptable for mobility into said electric fields. Said video based graphical user interface may display said video image frames of said patrolled area and a graphical display of corresponding electric field measurements. Therein, said graphical display of corresponding electric field measurements may be overlaid on said video image frames. Said graphical display of corresponding electric field measurements may be comprised of a raw electric field measurement plot, an adaptive threshold plot and a processed electric field measurement plot. Said adaptive threshold plot may be set relative to a local ambient or background noise level that is generated from data gathered prior to and proceeding measurement of raw electric field data. Said anomaly may be detected when said processed electric field measurement plot exceeds said adaptive threshold plot. A source of said anomaly may be identified by isolating an object discovered within close proximity to a peak of a spike in said raw electric field measurement plot. Said captured event depicting said anomaly may be recorded for subsequent analysis and action.

According to another embodiment, a method for presenting video and locally-generated graphics to a user at a computer having a display is provided. The method includes initializing and providing said user with a video-based graphical user interface on said display. The method includes displaying a video image frame of a patrolled area and electric field signal measurements in said graphical user interface on said display, wherein said electric field signal measurements are overlaid on said video image frame to provide a direct visual depiction of a location of a particular measurement. The method includes providing said user with an event capture option on said graphical user interface to identify a source in said captured event emitting said anomaly, and providing said user with playback controls on said graphical user interface for reviewing said captured event. The method may include storing and/or transmitting the captured event. The method may particularly include transmitting and receiving data associated with said captured events to and from at least one remote device. The method may include tagging a video image with instantaneous position information pertaining to location and time. The method may include emitting a variable-pitched tone corresponding to a strength value associated with said measured electric field signals. The method may include emitting an alert tone in response to a potentially detected stray voltage anomaly. Said graphical user interface displaying electric field signal measurements may further include displaying a raw electric field measurement plot, an adaptive threshold plot and a processed electric field measurement plot. The method may include setting said adaptive threshold plot to a local ambient or background noise level that is generated from data gathered prior to and proceeding measurement of raw electric field data. The method may include indicating a detection of said anomaly when said processed electric field measurement plot exceeds said adaptive threshold plot. The method may include identifying a source of said anomaly by isolating an object discovered within close proximity to a peak of a spike in said raw electric field measurement plot. The method may include recording said captured event depicting said anomaly for subsequent analysis and action. According to a further embodiment, a monitoring system comprising a computer having a display is provided. The computer is configured to carry out said method. According to a further embodiment, a computer readable medium is provided, the computer readable medium being encoded with machine-readable instructions for use in presenting video and locally generated graphics to a user at a computer having a display. The machine-readable instructions include information for carrying out said method.

One skilled in the art will appreciate that the present invention can be practiced by other than the described embodiments, which are presented for purposes of illustration and not by way of limitation, and the present invention is limited only by the claims that follow.

## Claims

1. An apparatus (100) mountable to a vehicle and configured for detecting a potential stray voltage anomaly event, the apparatus comprising:
a sensor probe (104a, 104b, 104c) configured to provide electric field measurement data;
means (112, 114) for providing a location reference associated with the electric field measurement data;
a processor (110) configured to detect, as the potential stray voltage anomaly event, a spike in the electric field measurement data that exceeds a threshold, and to tag the event with a corresponding location reference; and
at least one of:
a memory component (116) configured to store the potential stray voltage anomaly event, including storing the spike in the electric field measurement data and the tagged location reference, and
a transceiver component (118) configured to communicate the potential stray voltage anomaly event, including the tagged location reference, from the apparatus to a device.

2. The apparatus according to claim 1, wherein the means for providing a location reference comprises at least one of: a GPS receiver (114) configured to provide GPS position data to the processor, and a wheel speed sensor (112) configured to provide data pertaining to the speed and distance of travel of the vehicle to the processor, wherein the location reference includes at least one of the GPS position data and the data pertaining to the speed and distance of travel of the vehicle.

3. The apparatus according to one of the preceding claims, comprising a graphical user interface (120) that includes a main display (200) configured to display data, including data that is based on the electrical field measurement data and on the location reference.

4. The apparatus according to claim 3, wherein the main display comprises a video display (202) configured to display at least one graphical plot (406, 408, 410) showing the electrical field measurement data, or processed electrical field measurement data processed by the processor, as a function of the location reference.

5. The apparatus according to claim 4, wherein the at least one graphical plot includes a raw electrical field measurement plot (406), and the potential stray voltage anomaly event is indicated by a visual spike in the raw electric field measurement plot.

6. The apparatus according to claim 4, wherein the at least one graphical plot includes a raw electrical field measurement plot (406) and/or a smoothed plot (410) being a smoothed version of the raw electrical field measurement plot that has been filtered by the processor to remove spurious content, and wherein the at least one graphical plot includes an adaptive threshold plot (408) set relative to a local background noise, wherein the potential stray voltage anomaly event is indicated if the raw electrical field measurement plot or the smoothed plot exceeds the adaptive threshold plot.

7. The apparatus according to any of the preceding claims, wherein the main display (200) comprises a control panel (204), the control panel including a signal strength display field (522) providing a signal strength value of a measurement signal of the sensor probe, wherein the potential stray voltage anomaly event is indicated by a corresponding high signal strength value in the signal strength display field.

8. The apparatus according to any one the preceding claims, comprising an audible transducing device, particularly a loudspeaker, for producing an audible alarm, wherein the potential stray voltage anomaly event is indicated by a rise-peak-fall in an alert pitch of the audible alarm.

9. The apparatus according to claim 8, wherein the main display (200) comprises a control panel (204), the control panel including at least one of: an audio threshold indicator (504) representing a default setting of an audio threshold value indicative of a minimum level in the electric field measurement data required to trigger the audible alarm, and a preference command option (512) for modifying the audio threshold value.

10. A method for detecting a potential stray voltage anomaly event in a patrolled environment, the method comprising:
measuring an electric field in the patrolled environment and providing corresponding electric field measurement data;
providing a location reference associated with the electric field measurement data;
processing the electric field measurement data and the location reference, the processing including:
detecting, as the potential stray voltage anomaly event, a spike in the electric field measurement data that exceeds a threshold, and
tagging the potential stray voltage anomaly event with a corresponding location reference;
the method further comprising at least one of:
storing the potential stray voltage anomaly event, including storing the spike in the electric field measurement data and the tagged location, and
communicating the potential stray voltage anomaly event, including the tagged location, to a device.

11. The method according to claim 10, comprising displaying at least one graphical plot (406, 408, 410) showing the electrical field measurement data, or processed electrical field measurement data, as a function of the location reference, wherein the location reference optionally includes at least one of GPS position data and data pertaining to speed and distance of travel of a vehicle patrolling the patrolled environment.

12. The method according to claim 11, wherein the graphical plot is generated in real-time and displayed to an operator for monitoring the patrolled environment, or is generated from stored data and displayed to an operator for reviewing or analyzing the potential stray voltage anomaly event.

13. The method according to any one of claims 10-12, wherein the potential stray voltage anomaly event is indicated by a visual spike in the at least one plot.

14. The method according to any one of claims 10-13, comprising producing an audible alarm, wherein the potential stray voltage anomaly event is indicated by a rise-peak-fall in an alert pitch of the audible alarm.

15. The method according to any one of claims 10-14, comprising storing or transmitting an instruction to dispatch a utility crew to the location of the potential stray voltage event, optionally including identifying an energized object as a source of the potential stray voltage anomaly event.
